# EUROPEAN PATENT APPLICATION

(11) **EP 1 855 322 A1**
(43) Date of publication of application: **14.11.2007**
(21) Application number: 05819571.0
(22) Date of filing: 26.12.2005
(51) Int. Cl.: H01L 31/04

(54) **CRYSTALLINE SILICON WAFER, CRYSTALLINE SILICON SOLAR CELL, METHOD FOR MANUFACTURING CRYSTALLINE SILICON WAFER AND METHOD FOR MANUFACTURING CRYSTALLINE SILICON SOLAR CELL**

(30) Priority: 18.01.2005 JP 2005010319
(71) Applicant: Sharp Kabushiki Kaisha, Osaka-shi, Osaka 545-8522 (JP)
(72) Inventor: OTAKE, Yasutoshi, Toyama 930-0922 (JP); HAGINO, Masato, Kitakatsuragi-gun, Nara 635-0834 (JP)
(74) Representative: Müller, Frithjof E.
(86) International application number: PCT/JP2005/023793
(87) International publication number: WO 2006/077719

(57) **Abstract**

There is disclosed a crystalline silicon wafer (1) having irregularities formed at its surface. The irregularities include first irregularities (2) and second irregularities (3) smaller than the first irregularities (2). There are also disclosed a crystalline silicon wafer solar cell (11) using the crystalline silicon wafer (1), a method of manufacturing the crystalline silicon wafer (1), and a method of manufacturing the crystalline silicon wafer solar cell (11).

## Description

### TECHNICAL FIELD

The present invention relates to a crystalline silicon wafer, a crystalline silicon solar cell, a method of manufacturing the crystalline silicon wafer, and a method of manufacturing the crystalline silicon solar cell.

### BACKGROUND ART

A crystalline silicon wafer, which is most frequently used for a semiconductor device, is obtained from a monocrystalline silicon ingot made by a Czochralski (CZ) method or a polycrystalline silicon ingot made by a cast method, subjected to machining processes such as a block producing step, a profile grinding step, a slicing step, a lapping step, and others. Although not all these machining processes are performed, the block producing step and the slicing step are essential, and hence a surface of the wafer subjected to the slicing step has a damaged layer, namely, a work-affected layer formed thereat.

The machining processes and work-affected layer described above are explained in detail in Non-Patent Document 1 (Fumio Shimura, "Semiconductor Silicon Crystal Engineering", MARUZEN, CO., LTD, pp. 110-115). The work-affected layer is considered to include therein an amorphous layer, a polycrystalline layer, a mosaic layer, a crack layer, and a distorted layer. Additionally, the work-affected layer includes, as residues, abrasive grains and a lubricant used in processing, which have a high probability of causing adverse effects on subsequent steps as impurities. Accordingly, the work-affected layer is removed by chemical etching that uses, for example, an alkaline etching liquid.

In order to improve performance of the semiconductor device, however, it is also important to control a surface shape of the wafer, in addition to the removal of the work-affected layer at the wafer surface. In the so-called gettering technique, in which contaminants or impurities that have entered the wafer are captured in a region other than an active region of the semiconductor device, impurities in the wafer are subjected to gettering (are captured) by removing the above-described work-affected layer, and additionally, locally making the wafer surface porous to form a gettering site, and then performing heat treatment (e.g. see Patent Document 1 (Japanese Patent Laying-Open No. 11-16919)).

Among the semiconductor devices, a solar cell that converts optical energy in solar light into electrical energy has increasingly been developed in recent years to obtain various structures and configurations, with the growing interest in global environmental issues. Among them, a crystalline silicon solar cell that uses the crystalline silicon wafer is most commonly used because of its high conversion efficiency and low manufacturing cost.

In the conventional crystalline silicon solar cell, an antireflective film made of a silicon oxide film, a silicon nitride film, or the like is formed at a surface to improve its conversion efficiency. However, a film thickness thereof inevitably limits a wavelength range in which reflection is reduced. By stacking in a multilayered manner a plurality of antireflective films having different refractive indices, it is possible to expand the wavelength range of solar light in which reflection is reduced. However, increase in production steps inevitably raises manufacturing cost.

Accordingly, as means for reducing solar light reflection at the surface of the crystalline silicon solar cell by a simpler method, there is adopted a structure in which multiple irregularities are formed at the surface of the crystalline silicon wafer before the above-described antireflective film is formed thereat, to allow solar light reflected at the surface of the crystalline silicon wafer to be incident thereon again to reduce incident light loss caused by solar light reflection.

Usually, in the case where a crystalline silicon solar cell is fabricated with the use of a monocrystalline silicon wafer having a crystal orientation of plane (100), the wafer subjected to the slicing step is immersed in a 1-20 mass % sodium hydroxide aqueous solution containing isopropyl alcohol and kept at a temperature of 70-90°C, for approximately 30 minutes to 1 hour, so that multiple pyramid-shaped irregularities are formed at the surface of the monocrystalline silicon wafer. This method utilizes the fact that a plane {100}, a plane {110}, and a plane {111} at the surface of the monocrystalline silicon wafer have different chemical etching rates.

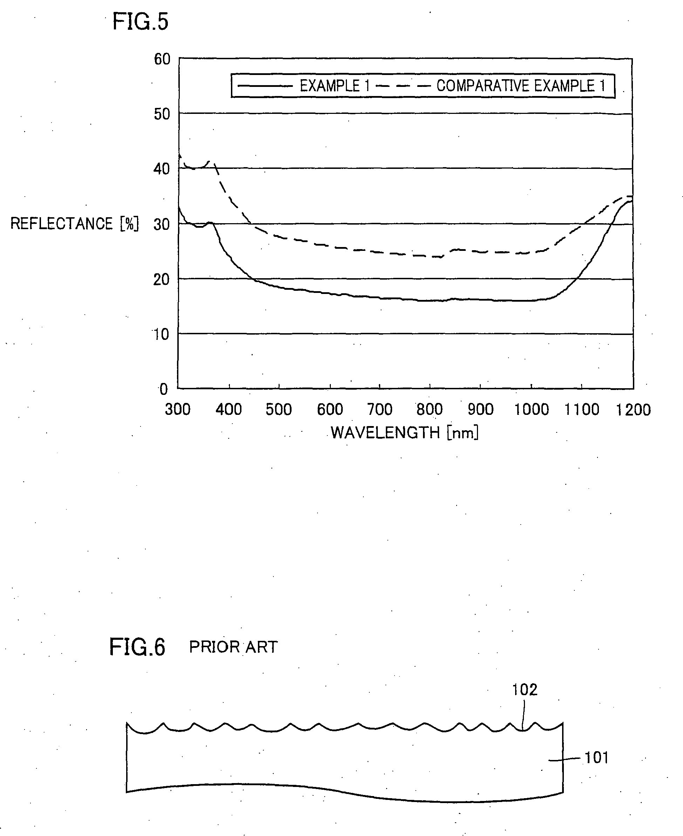

Alternatively, there is devised a method of obtaining irregularities 102 having spherical concave portions also at a polycrystalline silicon wafer 101 having non-uniform crystal planes, as shown in a schematic cross-sectional view in Fig. 6, by chemical etching in an acidic etching liquid mainly composed of hydrofluoric acid, nitric acid, phosphoric acid, and the like, instead of the above-described chemical etching that uses an alkaline aqueous solution (e.g. see Patent Document 2 (Japanese Patent Laying-Open No. 10-303443)).

As to another method, it is possible to consider, for example, mechanical processing that uses a rotary blade (blade) having diamond or silicon carbide embedded therein, laser etching, reactive gas etching, reactive ion etching (RIE), etching that utilizes photolithography, etching that utilizes masking, or the like.
Patent Document 1: Japanese Patent Laying-Open No. 11-16919
Patent Document 2: Japanese Patent Laying-Open No. 10-303443
Non-Patent Document 1: Fumio Shimura, "Semiconductor Silicon Crystal Engineering", MARUZEN, CO., LTD, pp. 110-115

### DISCLOSURE OF THE INVENTION

### PROBLEMS TO BE SOLVED BY THE INVENTION

The above-described chemical etching that uses an alkaline etching liquid is effective in fabrication of the monocrystalline silicon wafer oriented to a crystal plane (100). Even in that case, however, the sizes of the pyramid-like projections where a plane (111) serves as an inclined plane become non-uniform, and each of the irregularities at the surface has a random width ranging from approximately 0.1-30 µm, so that the surface of the monocrystalline silicon wafer lacks controllability in shape of the irregularities thereat.

Furthermore, as to the above-described chemical etching performed on the surface of the polycrystalline silicon wafer with the use of an alkaline etching liquid, this method cannot either significantly reduce solar light reflection at the surface of the polycrystalline silicon wafer, because the polycrystalline silicon wafer has various plane orientations.

Furthermore, in the case where the etching liquid contains isopropyl alcohol, it needs to be evaporated and removed when the etching liquid is drained, so that drainage processing requires efforts. Furthermore, the drainage processing must be performed at a high temperature of approximately 80°C for approximately 30 minutes, so that production stability is difficult to obtain from the viewpoint of controlling an alcohol component having high volatility.

Furthermore, the etching liquid described in Patent Document 2 (Japanese Patent Laying-Open No. 10-303443) needs to have phosphoric acid, carboxylic acid, a surfactant, and others added thereto, in addition to hydrofluoric acid and nitric acid. Accordingly, it is difficult to control a composition of the etching liquid. Furthermore, although it is possible with this method to obtain an irregular surface that has spherical concave portions each having a large width, the irregular surface alone having the spherical concave portions tends to allow solar light once reflected at the irregular surface to be reflected to the air, without allowing it to be incident again on the irregular surface. Accordingly, reduction of solar light reflection loss cannot be expected.

Furthermore, as to the methods such as mechanical processing that uses a rotary blade (blade), laser etching, reactive gas etching, reactive ion etching (RIE), etching that utilizes photolithography, or etching that utilizes masking, each of them cannot be performed in a single step, and is used with a step of removing by chemical etching a work-affected layer generated by a process of manufacturing a wafer or the above-described etching process. These methods require complicated means and high expenses.

In view of the foregoing, an object of the present invention is to provide a crystalline silicon wafer, a crystalline silicon solar cell, a method of manufacturing the crystalline silicon wafer, and a method of manufacturing the crystalline silicon solar cell, which can reduce solar light reflection loss at its surface.

### MEANS FOR SOLVING THE PROBLEMS

The present invention is a crystalline silicon wafer having irregularities formed at its surface, the irregularities including first irregularities and second irregularities smaller than the first irregularities.

In the crystalline silicon wafer according to the present invention, each of the first irregularities preferably has a width of not less than 10 µm and not more than 30 µm, and each of the first irregularities preferably has a height of not less than 5 µm and not more than 20 µm.

Furthermore, in the crystalline silicon wafer according to the present invention, each of the second irregularities preferably has a width of not less than 0.1 µm and not more than 5 µm, and each of the second irregularities preferably has a height of not less than 0.1 µm and not more than 3 µm.

Furthermore, the crystalline silicon wafer according to the present invention may be polycrystalline.

Furthermore, the present invention is a crystalline silicon solar cell having irregularities formed at its surface, the irregularities including first irregularities and second irregularities smaller than the first irregularities.

In the crystalline silicon solar cell according to the present invention, each of the first irregularities may have a width of not less than 10 µm and not more than 30 µm, and each of the first irregularities may have a height of not less than 5 µm and not more than 20 µm.

Furthermore, in the crystalline silicon solar cell according to the present invention, each of the second irregularities may have a width of not less than 0.1 µm and not more than 5 µm, and each of the second irregularities may have a height of not less than 0.1 µm and not more than 3 µm.

Furthermore, the crystalline silicon solar cell according to the present invention preferably uses polycrystalline silicon.

Furthermore, the present invention is a method of manufacturing a crystalline silicon wafer, including the steps of: slicing a crystalline silicon ingot by using a wire saw; and etching the sliced crystalline silicon ingot by using an etching liquid containing nitric acid having a nitric acid concentration of not less than 15 mass % and not more than 32 mass % and hydrofluoric acid having a hydrogen fluoride concentration of not less than 6 mass % and not more than 22 mass %.

In the method of manufacturing the crystalline silicon wafer according to the present invention, abrasive grains each having a grain size of not less than 10 µm and not more than 40 µm are preferably used in the step of slicing by using the wire saw.

Furthermore, the present invention is a method of manufacturing a crystalline silicon solar cell, including the steps of: slicing a crystalline silicon ingot by using a wire saw; and etching the sliced crystalline silicon ingot by using an etching liquid containing nitric acid having a nitric acid concentration of not less than 15 mass % and not more than 32 mass % and hydrofluoric acid having a hydrogen fluoride concentration of not less than 6 mass % and not more than 22 mass %.

The method of manufacturing the crystalline silicon solar cell according to the present invention may include the steps of forming a pn junction at the etched crystalline silicon wafer, and forming an electrode at the etched crystalline silicon wafer. Note that an order of formation of the pn junction and formation of the electrode is not limited in the present invention, and the pn junction and the electrode may be formed simultaneously.

### EFFECTS OF THE INVENTION

According to the present invention, it is possible to provide a crystalline silicon wafer, a crystalline silicon solar cell, a method of manufacturing the crystalline silicon wafer, and a method of manufacturing the crystalline silicon solar cell, which can reduce solar light reflection loss at a surface.

### BRIEF DESCRIPTION OF THE DRAWINGS

Fig. 1 is a schematic cross-sectional view of a preferable example of a crystalline silicon wafer according to the present invention.
Fig. 2 is a schematic cross-sectional view showing an example of a process, in the present invention, from removal of a work-affected layer by chemical etching to formation of the crystalline silicon wafer according to the present invention.
Fig. 3 is a schematic cross-sectional view of a preferable example of a crystalline silicon solar cell according to the present invention.
Fig. 4 is a schematic cross-sectional view showing a preferable example of steps of manufacturing the crystalline silicon solar cell according to the present invention.
Fig. 5 is a drawing that shows a relation between a wavelength of light incident on a surface of a crystalline silicon wafer in each of Example 1 and Comparative Example 1, and a reflectance.
Fig. 6 is a schematic cross-sectional view of an example of a crystalline silicon wafer obtained by a conventional method.
Fig. 7(a) is a schematic plan view illustrating a method of specifying a width of second irregularities at a surface of the crystalline silicon wafer according to the present invention, and Fig. 7(b) is a schematic cross-sectional view illustrating a method of specifying a height of the second irregularities at the surface of the crystalline silicon wafer according to the present invention.
Fig. 8 is a schematic cross-sectional view illustrating a method of specifying a height and a width of first irregularities at the surface of the crystalline silicon wafer according to the present invention.

### DESCRIPTION OF THE REFERENCE SIGNS

1 crystalline silicon wafer, 2 first irregularities, 3 second irregularities, 11 crystalline silicon solar cell, 13 n-type diffusion layer, 14 antireflective film, 15 BSF layer, 16 aluminum electrode, 16a aluminum paste, 17, 18 silver electrode, 17a, 18a silver paste, 24 work-affected layer, 21 silicon wafer, 101 polycrystalline silicon wafer, 102 irregularities having spherical concave portions.

### BEST MODES FOR CARRYING OUT THE INVENTION

The embodiment of the present invention will hereinafter be described. In the drawings of the present invention, the same reference characters represent the same or corresponding portions.

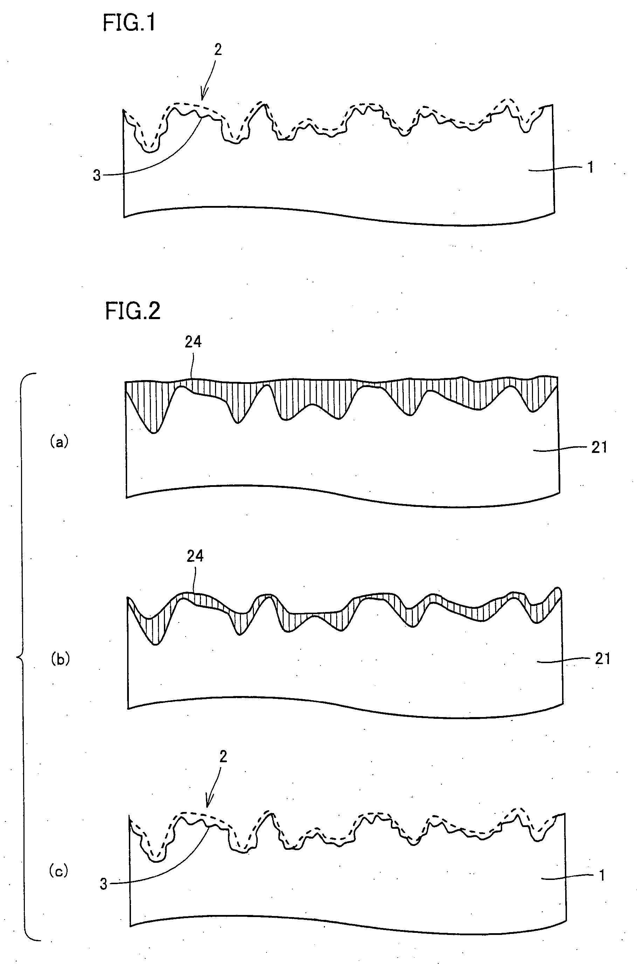

Fig. 1 is a schematic cross-sectional view showing a preferable example of a crystalline silicon wafer according to the present invention. Irregularities are formed at a surface of a crystalline silicon wafer 1 shown in Fig. 1, and the irregularities include first irregularities 2 (large irregularities surrounded by a broken line) having large corrugations and formed at an entire surface of crystalline silicon wafer 1, and second irregularities 3 (small irregularities described by a solid line) having corrugations smaller than those of first irregularities 2 and formed at first irregularities 2. A width of each of first irregularities 2 is not less than 10 µm and not more than 30 µm, while a height of each of first irregularities 2 is not less than 5 µm and not more than 20 µm. A width of each of second irregularities 3 is not less than 0.1 µm and not more than 5 µm, while a height of each of second irregularities 3 is not less than 0.1 µm and not more than 3 µm. Note that, as to the fact that first irregularities 2 are formed through a two-stage step including a slicing step and a chemical etching step described below, first irregularities 2 are formed mainly by the slicing step described below, while second irregularities 3 are formed mainly by the chemical etching step described below.

In the case where only first irregularities 2 having larger corrugations are formed, or in the case where only second irregularities 3 having smaller corrugations are formed, reflection can be reduced when compared with a flat surface. However, solar light incident on the surface of crystalline silicon wafer 1 tends not to be incident on the surface of crystalline silicon wafer 1 again after reflection, diffraction, or scattering at the surface of crystalline silicon wafer 1. Accordingly, there is a low probability for solar light to be incident in crystalline silicon wafer 1.

In contrast, in the crystalline silicon wafer according to the present invention, owing to first irregularities 2 and second irregularities 3, which have the widths and heights falling within the above-described ranges, solar light incident on the surface of crystalline silicon wafer 1 tends to be incident on the surface of crystalline silicon wafer 1 again after reflection, diffraction, or scattering at the surface of crystalline silicon wafer 1. Accordingly, there is a high probability for solar light to be incident in crystalline silicon wafer 1. For example, solar light that is reflected, diffracted, scattered, or the like at second smaller irregularities 3 is incident again toward first larger irregularities 2, which stand surrounding the smaller irregularities, without escaping to the outside, so that there is a higher probability for solar light to be absorbed in crystalline silicon wafer 1. In the crystalline silicon wafer according to the present invention, it is therefore possible to reduce solar light reflection loss at the surface of the crystalline silicon wafer.

The widths and heights of first irregularities 2 and second irregularities 3 set to fall within the above-described ranges are derived from various experimental results in view of the current slicing technique and chemical etching technique. Inventors of the present invention have found that it is possible to obtain with favorable reproducibility a crystalline silicon wafer in which solar light reflection loss is reduced, by setting the widths and heights of first irregularities 2 and second irregularities 3 to fall within the above-described ranges.

In other words, first irregularities 2 are formed mainly by a step of slicing a crystalline silicon ingot or a crystalline silicon ingot subjected to a block producing process. At that time, if a height of each of first irregularities 2 exceeds 20 µm, a thickness of the silicon wafer, which is generally 150 µm-500 µm, is reduced by up to 40 µm in total on both sides. In this case, accordingly, a crack is likely to occur in the silicon wafer, so that the crystalline silicon wafer according to the present invention seems to be less likely to be obtained with favorable reproducibility. Alternatively, if a height of each of first irregularities 2 is less than 5 µm, first irregularities 2 become so low that the above-described solar light reflection loss tends not to be reduced. Furthermore, it is difficult to control a width of each of first irregularities 2 to be less than 10 µm while the height of each of first irregularities 2 is maintained to be not less than 5 µm. Accordingly, each of first irregularities 2 preferably has a width of not less than 10 µm so as to obtain with favorable reproducibility the crystalline silicon wafer according to the present invention. If a width of each of first irregularities 2 exceeds 30 µm, the width thereof becomes excessively large, so that the above-described solar light reflection loss tends not to be reduced.

Second irregularities 3 are formed mainly by chemical etching that uses an acidic etching liquid described below. As to the shape of second irregularities 3, the irregularities tend to become large, and heights and widths thereof also tend to increase, as etching proceeds. However, the ratio of width to height is increased to cause planarization, which inhibits the above-described reduction in solar light reflection loss. Accordingly, each of second irregularities 3 preferably has a height of not more than 3 µm and a width of not more than 5 µm. Furthermore, it is very difficult to control both of the width and height of each of second irregularities 3 to be less than 0.1 µm, so that each of second irregularities 3 preferably has a width and a height of not less than 0.1 µm, so as to obtain with favorable reproducibility the crystalline silicon wafer according to the present invention.

Note that it is possible in the present invention to specify whether or not the widths and the heights of first irregularities 2 and second irregularities 3 fall within the above-described ranges, for example, as follows. Initially, a laser displacement meter in a laser microscope, an optical microscope, or the like is used to measure a profile of the surface of crystalline silicon wafer 1 at approximately 1000 to 1500-fold magnification. This makes it possible to observe first irregularities 2 having large corrugations, and second irregularities 3 smaller than first irregularities 2 and having spherical or approximately spherical concave portions.

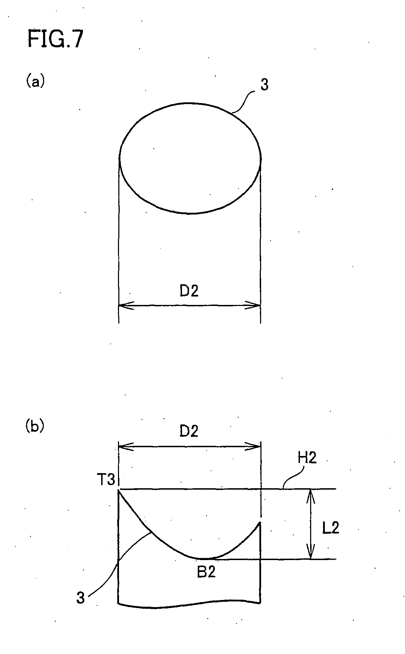

A width of second irregularities 3 according to the present invention is calculated by measuring a maximum width D2 of a concave portion of second irregularities 3 shown in a schematic enlarged plan view in Fig. 7(a), which is obtained when the surface of crystalline silicon wafer 1 provided to face upward is observed from above in a direction perpendicular to the surface itself. A height of second irregularities 3 is calculated by measuring a length L2 of a plumb line having a portion B2 that protrudes most downwardly, as a starting point, and having a level H2 on which a point T3 protruding most upwardly in convex portions of second irregularities 3 exists, as an endpoint, in Fig. 7(b) identified as a cross-sectional view taken along maximum width D2 shown in Fig. 7(a).

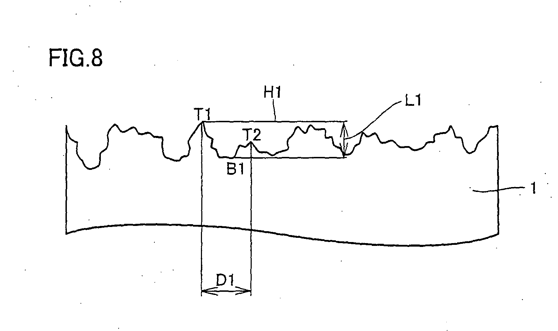

In contrast, a width of first irregularities 2 according to the present invention, which are preferably formed in a corrugated manner over a range larger than that of second irregularities 3, is calculated by measuring a horizontal distance D1 between a point T 1 protruding most upwardly in any one of the convex portions of first irregularities 2 (hereinafter referred to as a "top portion") and a top portion T2 of a convex portion adjacent to the convex portion, when the surface of crystalline silicon wafer 1 is provided to face upward as shown in a schematic cross-sectional view in Fig. 8. A height of first irregularities 2 is calculated by measuring a length L1 of a plumb line having a portion B1 that protrudes most downwardly between top portion T1 and top portion T2, as a starting point, and having a level H1 on which a point protruding most upwardly between top portion T1 and top portion T2 exists, as an endpoint, in the same cross section as that used for specifying the width of first irregularities 2.

An example of a method of manufacturing crystalline silicon wafer 1 shown in Fig. 1 will hereinafter be described. The inventors of the present invention have found that the condition of a step of slicing a crystalline silicon ingot, as well as the condition of chemical etching, needs to be considered to form first irregularities 2 and second irregularities 3 described above at the surface of crystalline silicon wafer 1.

Initially, there is prepared a monocrystalline silicon ingot or a polycrystalline silicon ingot for fabricating a crystalline silicon wafer. The monocrystalline silicon ingot is fabricated by, for example, a Czochralski method, while the polycrystalline silicon ingot is fabricated by, for example, a cast method.

The monocrystalline silicon ingot or the polycrystalline silicon ingot obtained as such is processed into a block with a desired size by means of a band saw. At this time, the monocrystalline silicon ingot is processed into a cylindrical block having a circular base with a diameter of approximately 5-8 inches and having a height of approximately 100 cm, while the polycrystalline silicon ingot is processed into a rectangular parallelepiped block having a rectangular base with a side of approximately 100-155 mm, for example, and having a height of approximately 20 cm.

The monocrystalline silicon ingot or the polycrystalline silicon ingot, which has processed into a block, is sliced to have a desired thickness by means of a wire saw provided with a multiwire and abrasive grains.

Fig. 2(a) is a schematic cross-sectional view of an example of a silicon wafer obtained by slicing the monocrystalline silicon ingot or the polycrystalline silicon ingot. A silicon wafer 21 shown in Fig. 2(a), which is obtained through slicing, has a work-affected layer 24 generated by a mechanical damage during slicing. At this time, the wafer has less irregularities formed thereat and has a flat surface as shown in Fig. 2(a).

A depth of work-affected layer 24 is under the influence of a wire diameter, a wire speed, a pressure, and others of the wire saw. The inventors focused on the fact that the depth greatly depends on a grain size of each of the abrasive grains used for the wire saw. Upon elaborate examination, the inventors have found that the depth of work-affected layer 24 varies in silicon wafer 21 in certain cycles. This is thought to have a correlation with a grain size of each of the abrasive grains, and it has been found that each of the abrasive grains preferably has a grain size of not less than 10 µm and not more than 40 µm so as to control the width of each of first irregularities 2 to be not less than 10 µm and not more than 30 µm and control the height of each of first irregularities 2 to be not less than 5 µm and not more than 20 µm. At this time, it is possible to specify whether or not each of the abrasive grains has a grain size of not less than 10 µm and not more than 40 µm by, for example, observing the abrasive grains with an electron microscope, measuring an average grain size by a centrifugal settling scheme, measuring grain size distribution by allowing light to scatter and diffract, or the like.

Work-affected layer 24 formed at silicon wafer 21 by the above-described slicing can be removed by chemical etching that uses an acidic etching liquid. Fig. 2(b) shows silicon wafer 21 that is being subjected to chemical etching, and Fig. 2(c) shows a schematic cross-sectional view of crystalline silicon wafer 1 after the completion of chemical etching. The etching liquid used for this chemical etching contains nitric acid having a nitric acid concentration of not less than 10 mass % and not more than 32 mass %, and hydrofluoric acid having a hydrogen fluoride concentration of not less than 6 mass % and not more than 22 mass %. At this time, the nitric acid concentration is preferably not less than 19 mass % and not more than 29 mass %, and more preferably not less than 22 mass % and not more than 27 mass %. The hydrogen fluoride concentration is preferably not less than 8 mass % and not more than 16 mass %, and more preferably not less than 10 mass % and not more than 14 mass %. As the nitric acid concentration and the hydrogen fluoride concentration of the etching liquid are set to fall within the preferable ranges and the more preferable ranges described above, a desirable and suitable surface having the above-described first irregularities and second irregularities is more likely to be obtained, and etching that only requires a short period of time of approximately 1-3 minutes, for example, at a normal temperature of 10-30°C, for example, is more likely to be feasible, so that chemical etching excellent in mass productivity and mass-production stability is more likely to be feasible.

The above-described chemical etching that uses an acidic etching liquid is based on oxidation of silicon by nitric acid, and melting and removal of silicon oxide by hydrofluoric acid, and hence does not depend on a crystal plane orientation. In other words, it is considered that, at the surface of the silicon wafer having a work-affected layer, there exists a portion where a bond between silicon atoms is mechanically broken by the slicing step, and etching proceeds starting from weakly-bonded silicon atoms to form spherical or approximately spherical second irregularities 3.

By using an etching liquid having the above-described composition and concentration ranges, it is possible to promote chemical etching along the depth of work-affected layer 24, as shown in Figs. 2(b) and 2(c).

Although second irregularities 3 are identified as small irregularities and schematically shown by a smooth line at a stage in Fig. 2(b), they become large as chemical etching proceeds, to achieve the size shown in Fig. 2(c). Note that, although chemical etching rate depends on a temperature, chemical etching is excellent in production stability because it does not cause variations in final shape shown in Fig. 2(c) as long as an amount to be chemically etched is set constant whenever chemical etching is performed.

In the present invention, the above-described, desired irregular shape can be obtained by performing a chemical etching process preferably for approximately 1-3 minutes with an etching liquid preferably at approximately 10-30°C. Accordingly, when compared with the conventional case where a process is performed for 30 minutes with an etching liquid at approximately 80°C, no heater is required, a period of time is significantly reduced, and mass productivity of the crystalline silicon wafer is significantly improved. Consequently, as shown in Fig. 2(c), it is possible to obtain, with high reproducibility, crystalline silicon wafer 1 having both of first irregularities 2 and second irregularities 3 by completely removing the work-affected layer and then removing a minimum necessary thickness of the surface of crystalline silicon wafer 1. Accordingly, there is obtained a structure in which adverse effects that would be caused by the work-affected layer containing abrasive grains, a cutting fluid, and the like are reduced in a subsequent step during fabrication of the semiconductor device, and solar light incident on the surface of crystalline silicon wafer 1 is efficiently captured in crystalline silicon wafer 1, so that solar light reflection loss can be reduced.

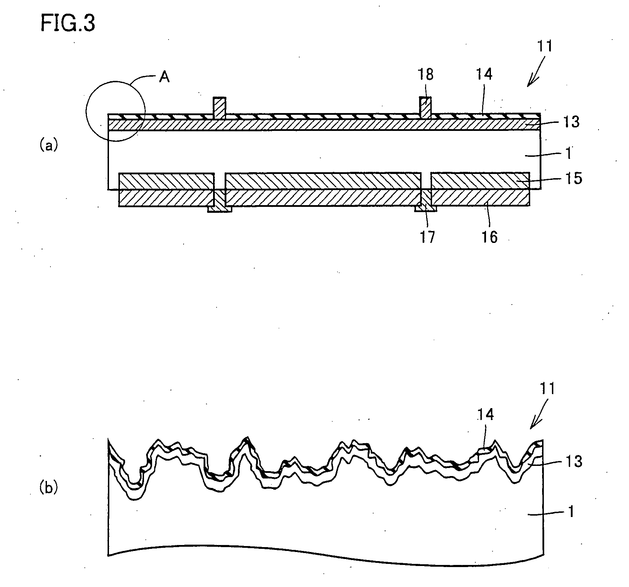

The crystalline silicon wafer obtained as such is suitably used for a crystalline silicon solar cell. Fig. 3(a) is a schematic cross-sectional view of a favorable example of a crystalline silicon solar cell according to the present invention. Note that a thickness of each part in Fig. 3(a) is not shown exactly, but shown schematically.

A crystalline silicon solar cell 11 uses p-type crystalline silicon wafer 1 as a base material to serve as a semiconductor substrate, and has an n-type diffusion layer 13 formed in proximity to the surface, which is to serve as a light-receptive surface. On n-type diffusion layer 13, there is formed an antireflective film 14 made of silicon nitride, titanium oxide, or the like. A silver electrode 18 is formed on a side of the light-receptive surface of crystalline silicon solar cell 11, while a BSF (Back Surface Field) layer 15 containing a p-type dopant of an amount larger than that of crystalline silicon wafer 1 is formed at a back surface of crystalline silicon wafer 1, which back surface is located opposite to the light-receptive surface. Furthermore, an aluminum electrode 16 is formed on BSF layer 15, and a silver electrode 17 is formed such that it fills a linear gap formed in aluminum electrode 16 and further overlaps aluminum electrode 16. Surfaces of silver electrode 17 and silver electrode 18 shown in Fig. 3(a) may also be coated with a solder.

Fig. 3(b) shows a schematic cross-sectional view showing a portion A shown in Fig. 3(a) in an enlarged manner. As shown in Fig. 3(b), n-type diffusion layer 13 and antireflective film 14 are formed to extend along the irregularities formed at the surface of crystalline silicon wafer 1 of crystalline silicon solar cell 11. As described above, the light-receptive surface of crystalline silicon solar cell 11 adopts a structure in which incident solar light is efficiently captured in crystalline silicon wafer 1. It is therefore possible to obtain a crystalline silicon solar cell suffering less solar light reflection loss, having high photocurrent density, and having high conversion efficiency.

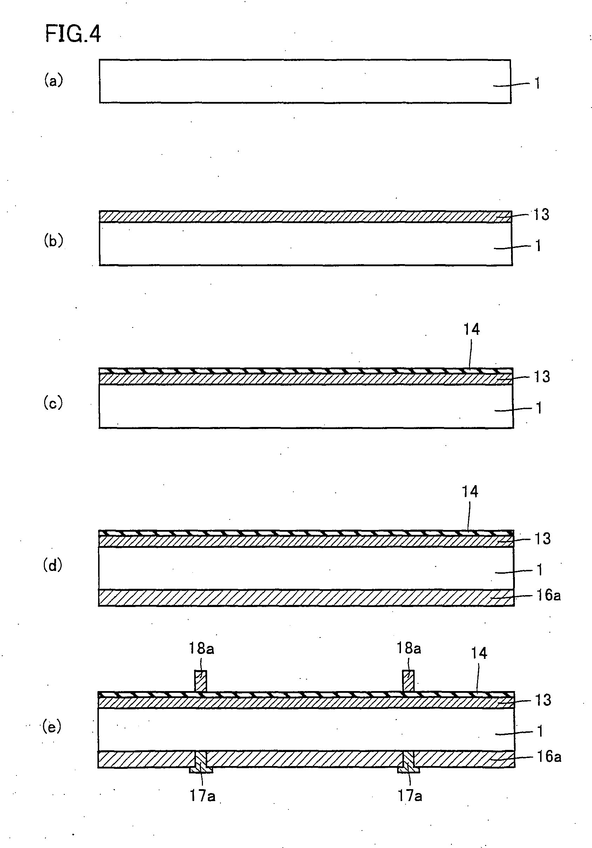

A method of manufacturing an example of the crystalline silicon solar cell according to the present invention will hereinafter be described with reference to Figs. 4(a)-(e). Note that a thickness of each part in Figs. 4(a)-(e) is not shown exactly, but shown schematically.

As shown in Fig. 4(a), there is initially prepared crystalline silicon wafer 1 having a p-type conductivity type and having first irregularities 2 and second irregularities 3, which are obtained as described above, formed at the surface thereof. At this time, it is preferable that the method includes a step of treating crystalline silicon wafer 1 with a dilute alkaline aqueous solution. This is because a black or brown thin film, which may be formed at the surface of the crystalline silicon wafer during the above-described chemical etching that uses an etching liquid, can be removed by treating the surface of the crystalline silicon wafer with an alkaline aqueous solution. For the alkaline aqueous solution, it is possible to use, for example, a sodium hydroxide aqueous solution, an ammonia aqueous solution, or the like. From the viewpoint of sufficiently removing the thin film, the alkaline aqueous solution preferably has a solute concentration of not less than 0.1 mass % and not more than 5 mass %, and more preferably not less than 0.5 mass % and not more than 1 mass %. Furthermore, from the viewpoint of efficiently removing the thin film, a period of time for treatment with the alkaline aqueous solution is preferably not less than 5 seconds and not more than 30 seconds.

Next, as shown in Fig. 4(b), an n-type dopant is diffused at the surface of crystalline silicon wafer 1, which is to serve as a light-receptive surface, to form n-type diffusion layer 13. A pn junction is thereby formed in crystalline silicon wafer 1. Note that it is also possible in the present invention to fabricate a back surface junction-type crystalline silicon solar cell in which n-type diffusion layer 13 is formed at a part of the back surface, which is located opposite to the light-receptive surface, to form a pn junction at the back surface of crystalline silicon wafer 1.

Subsequently, as shown in Fig. 4(c), antireflective film 14 is formed on n-type diffusion layer 13. As shown in Fig. 4(d), an aluminum paste 16a is screen-printed at the back surface of crystalline silicon wafer 1 and then exposed to an atmosphere at approximately 150°C to dry the same. Next, as shown in Fig. 4(e), a silver paste 17a is screen-printed at the back surface of crystalline silicon wafer 1 such that it overlaps aluminum paste 16a, and then dried. A silver paste 18a is also screen-printed on antireflective film 14 and then dried.

Thereafter, crystalline silicon wafer 1 is allowed to pass through a belt-type baking furnace having a peak temperature set at approximately 750°C, for example, so that silver paste 18a at the light-receptive surface, and silver paste 17a at the back surface, of crystalline silicon wafer 1 are fired. Accordingly, silver paste 18a on the side of the light-receptive surface of crystalline silicon wafer 1 fires through antireflective film 14 to be a silver electrode electrically brought into contact with the light-receptive surface of crystalline silicon wafer 1. As to the back surface of crystalline silicon wafer 1, aluminum paste 16a is diffused at the back surface of crystalline silicon wafer 1 to form a BSF layer. Furthermore, silver paste 17a screen-printed at the back surface of crystalline silicon wafer 1 is also fired so that a silver electrode is formed. As such, there is formed a crystalline silicon solar cell according to the present invention shown in Fig. 3(a).

Note that, in a back surface junction-type crystalline silicon solar cell having a pn junction formed at the back surface of crystalline silicon wafer 1, a silver electrode is formed only at the back surface of crystalline silicon wafer 1. There is no need to form the same at the light-receptive surface.

Alternatively, aluminum paste 16a and silver pastes 17a and 18a may be fired at different temperatures, respectively. In this case, it is preferable that aluminum paste 16a is fired at a temperature of approximately 700°C-800°C, while silver pastes 17a and 18a are fired at a temperature of approximately 500°C-600°C.

Furthermore, in the foregoing, the silver electrode formed at the light-receptive surface and/or the back surface of crystalline silicon wafer 1 may also be coated with solder by immersing crystalline silicon wafer 1 in a solder bath.

The surface of the crystalline silicon solar cell according to the present invention formed as such (the surface of the antireflective film in the crystalline silicon solar cell shown in the present embodiment) also has first irregularities and second irregularities smaller than the first irregularities formed thereat. A width of each of the first irregularities is not less than 10 µm and not more than 30 µm, while a height of each of the first irregularities is not less than 5 µm and not more than 20 µm. A width of each of the second irregularities is not less than 0.1 µm and not more than 5 µm, while a height of each of the second irregularities is not less than 0.1 µm and not more than 3 µm. It is therefore possible in the crystalline silicon solar cell according to the present invention to reduce solar light reflection loss at its surface, and hence it is possible to improve an output. A method of specifying the widths and the heights of the first irregularities and the second irregularities at the surface of the crystalline silicon solar cell according to the present invention is similar to that in the case of the crystalline silicon wafer described above.

### Example

### (Example 1)

Initially, a polycrystalline silicon ingot was formed by a cast method. In the cast method, a polycrystalline silicon ingot was formed by slowly cooling silicon melted in a casting mold (cast) at a temperature of approximately 1400°C to 1500°C, which temperature is equal to or higher than a melting point of silicon, and solidifying the same.

The polycrystalline silicon ingot was removed from the casting mold, and processed with a band saw into a rectangular parallelepiped block having a square base with a side of 125 mm and a thickness of approximately 20 cm. The polycrystalline silicon ingot subjected to the block producing process as described above was sliced by means of a wire saw provided with a multiwire and abrasive grains made of SiC (silicon carbide), so that there were obtained silicon wafers each having a thickness of 300 µm. At that time, each of the abrasive grains had a grain size of not less than 10 µm and not more than 40 µm.

The silicon wafer obtained as such had a work-affected layer formed at its surface. The abrasive grains and a cutting fluid, which had been used in the above-described slicing step, were left in the work-affected layer, and hence the work-affected layer was removed with an etching liquid.

For the etching liquid, there was used a mixture made by mixing pure water, nitric acid having a nitric acid concentration of 60 mass %, and hydrofluoric acid having a hydrogen fluoride concentration of 49 mass % such that the volume ratios of pure water : nitric acid : hydrofluoric acid were 6 : 7 : 5. Note that the nitric acid having a nitric acid concentration of 60 mass % had a specific gravity of 1.38, while the hydrofluoric acid having a hydrogen fluoride concentration of 49 mass % had a specific gravity of 1.17, and hence this etching liquid had a nitric acid concentration of 26.9 mass % and a hydrogen fluoride concentration of 13.3 mass %.

The above-described etching was performed with the etching liquid set at 21°C. Specifically, the wafer subjected to the above-described slicing step was placed at a wafer holding cassette made of tetrafluoroethylene, which was then vertically immersed in the above-described etching liquid. The wafer holding cassette was pulled out 120 seconds after the initiation of immersion, and a surface of the silicon wafer was immediately rinsed with pure water so as to stop etching. At that time, a black or brown thin film was formed at the surface of the rinsed silicon wafer, so that the thin film was removed by immersing the silicon wafer, for 30 seconds, in a sodium hydroxide aqueous solution having a sodium hydroxide concentration of 0.1 mass % and kept at a room temperature. As such, a crystalline silicon wafer in Example 1 was fabricated. Upon examination of irregularities at the surface of the crystalline silicon wafer in Example 1 obtained as such by means of an optical microscope, all the widths of the first irregularities fell within a range of not less than 10 µm and not more than 30 µm, and all the heights thereof fell within a range of not less than 5 µm and not more than 20 µm. All the widths of the second irregularities fell within a range of not less than 0.1 µm and not more than 5 µm, and all the heights thereof fell within a range of not less than 0.1 µm and not more than 3 µm.

A reflectance of light with various wavelengths was measured by applying the light to the surface of the crystalline silicon wafer in Example 1. The results are shown in Fig. 5. In Fig. 5, an axis of abscissas represents a wavelength of the applied light, while an axis of ordinates represents its reflectance. The reflectance in Fig. 5 is a mean value of measured reflectances at four arbitrary points at the surface of the crystalline silicon wafer.

For comparison, a crystalline silicon wafer in Comparative Example 1 was fabricated in a manner similar to that described above, except that the wafer was chemically etched by being immersed, for 10 minutes, in a sodium hydroxide aqueous solution having a sodium hydroxide concentration of 20 mass % and kept at 90°C, instead of being immersed in the above-described etching liquid made of nitric acid, hydrofluoric acid, and pure water. As to the crystalline silicon wafer in Comparative Example 1, a reflectance was also measured in a manner similar to that of the crystalline silicon wafer in Example 1. The results are also shown in Fig. 5.

As is clear from Fig. 5, the reflectance as to the crystalline silicon wafer in Example 1 is found to be generally lower than that as to the crystalline silicon wafer in Comparative Example 1 over the entire range of wavelengths. This is because Comparative Example 1 adopted etching that depended on an orientation of a crystal plane instead of etching that depended on a depth of the work-affected layer as in Example 1, so that the irregularities at the surface of the crystalline silicon wafer could not sufficiently be controlled, resulting in that the most part of the surface of the crystalline silicon wafer was planarized when compared with Example 1. Upon examination of the irregularities at the surface of the crystalline silicon wafer in Comparative Example 1 by means of an optical microscope, they did not assume the two-step irregular shape made of first irregularities and second irregularities as in the surface of the crystalline silicon wafer in Example 1, but assumed a one-step irregular shape having a height of approximately 1-5 µm and a width of approximately 2-30 µm.

### (Example 2)

A crystalline silicon solar cell was fabricated with the use of the crystalline silicon wafer in Example 1. For comparison, a crystalline silicon solar cell was fabricated with the use of the crystalline silicon wafer in Comparative Example 1. At that time, these crystalline silicon wafers had a p-conductivity type, and had a specific resistance of approximately 1 Ω • cm.

Next, a diffusing agent containing phosphorus was applied to the surfaces of the crystalline silicon wafers, which surfaces were to serve as light-receptive surfaces, and the crystalline silicon wafers were heated to 900°C to thermally diffuse phosphorus in the light-receptive surfaces of these crystalline silicon wafers, so that n-type diffusion layers having a sheet resistance value of approximately 50 Ω were formed.

Next, on each of the n-type diffusion layers, there was deposited a silicon nitride film having a thickness of approximately 70 nm by a plasma CVD method, to serve as an antireflective film. Subsequently, at each of the back surfaces of these crystalline silicon wafers, an aluminum paste was screen-printed to have a thickness of approximately 30 µm, and the screen-printed aluminum paste was dried at 150°C for 5 minutes to remove a solvent contained in the aluminum paste.

Furthermore, at each of the back surfaces of these crystalline silicon wafers, a silver paste was screen-printed in a pattern-like manner and then dried. At each of the light-receptive surfaces of these crystalline silicon wafers, a silver paste was screen-printed in a fishbone pattern and then dried.

Thereafter, these crystalline silicon wafers were fired at 750°C for 2 minutes to fire the aluminum paste and the silver paste screen-printed at the light-receptive surfaces and the back surfaces thereof, so that electrodes were formed at the light-receptive surface and the back surface of each of the crystalline silicon wafers. During the firing, a BSF layer was formed at the back surface of each of these crystalline silicon wafers by allowing aluminum to diffuse from the aluminum paste, while silver electrodes were formed at the light-receptive surface and the back surface of each of the crystalline silicon wafers. The silver paste on the side of each of the light-receptive surfaces fired through the antireflective film to be the silver electrode.

Lastly, these crystalline silicon wafers were immersed in a solder bath so that the surfaces of the silver electrodes formed at the light-receptive surface and the back surface of each of the crystalline silicon wafers were coated with solder As such, there were obtained a crystalline silicon solar cell in Example 2 (where the crystalline silicon wafer in Example 1 was used) and a crystalline silicon solar cell in Comparative Example 2 (where the crystalline silicon wafer in Comparative Example 1 was used).

An output, an open-circuit voltage, a short-circuit current, and a fill factor of each of the crystalline silicon solar cells were evaluated with a solar simulator. The results of the evaluation are shown in Table 1.

**[Table 1]**

| | Example 2 | Comparative Example 2 |
|---|---|---|
| Output (W) | 2.50 | 2.39 |
| Open-Circuit Voltage (V) | 0.617 | 0.618 |
| Short-Circuit Current (A) | 5.220 | 4.980 |
| Fill Factor | 0.777 | 0.775 |

As is clear from Table 1, the crystalline silicon solar cell in Example 2 was improved in short-circuit current by approximately 4.8%, in output by approximately 4.6%, when compared with the crystalline silicon solar cell in Comparative Example 2. This seems to be attributable to the fact that, in the crystalline silicon solar cell in Example 2, solar light reflection loss at the light-receptive surface was reduced and hence light incident in the solar cell could be utilized effectively.

Upon examination of the irregularities at the surface of the crystalline silicon solar cell in Example 2 by means of an optical microscope, all the widths of the first irregularities fell within a range of not less than 10 µm and not more than 30 µm, and all the heights thereof fell within a range of not less than 5 µm and not more than 20 µm. All the widths of the second irregularities fell within a range of not less than 0.1 µm and not more than 5 µm, and all the heights thereof fell within a range of not less than 0.1 µm and not more than 3 µm. Upon examination of the irregularities at the surface of the crystalline silicon solar cell in Comparative Example 2 by means of an optical microscope, they did not assume the two-step irregular shape made of first irregularities and second irregularities as in the surface of the crystalline silicon solar cell in Example 2, but assumed the one-step irregular shape having a height of approximately 1-5 µm and a width of approximately 2-30 µm.

It should be understood that the embodiments and examples disclosed herein are illustrative and not limitative in all aspects. The scope of the present invention is shown not by the description above but by the scope of the claims, and is intended to include all modifications within the equivalent meaning and scope of the claims.

### INDUSTRIAL APPLICABILITY

According to the present invention, each of the first irregularities formed at the surface has a width of not less than 10 µm and not more than 30 µm, and a height of not less than 5 µm and not more than 20 µm, while each of the second irregularities has a width of not less than 0.1 µm and not more than 5 µm, while a height of not less than 0.1 µm and not more than 3 µm. Accordingly, it is possible to reduce solar light reflection loss at the surface.

## Claims

1. A crystalline silicon wafer (1) having irregularities formed at its surface, said irregularities including first irregularities (2) and second irregularities (3) smaller than said first irregularities.

2. The crystalline silicon wafer (1) according to claim 1, wherein each of said first irregularities (2) has a width of not less than 10 µm and not more than 30 µm, and each of said first irregularities (2) has a height of not less than 5 µm and not more than 20 µm.

3. The crystalline silicon wafer (1) according to claim 1, wherein each of said second irregularities (3) has a width of not less than 0.1 µm and not more than 5 µm, and each of said second irregularities (3) has a height of not less than 0.1 µm and not more than 3 µm.

4. The crystalline silicon wafer (1) according to claim 1, wherein the crystalline silicon wafer (1) is polycrystalline.

5. A crystalline silicon solar cell (11) having irregularities formed at its surface, said irregularities including first irregularities (2) and second irregularities (3) smaller than said first irregularities (2).

6. The crystalline silicon solar cell (11) according to claim 5, wherein each of said first irregularities (2) has a width of not less than 10 µm and not more than 30 µm, and each of said first irregularities (2) has a height of not less than 5 µm and not more than 20 µm.

7. The crystalline silicon solar cell (11) according to claim 5, wherein each of said second irregularities (3) has a width of not less than 0.1 µm and not more than 5 µm, and each of said second irregularities (3) has a height of not less than 0.1 µm and not more than 3 µm.

8. The crystalline silicon solar cell (11) according to claim 5, wherein the crystalline silicon solar cell (11) uses polycrystalline silicon.

9. A method of manufacturing a crystalline silicon wafer (1), comprising the steps of slicing a crystalline silicon ingot by using a wire saw; and etching said sliced crystalline silicon ingot by using an etching liquid containing nitric acid having a nitric acid concentration of not less than 15 mass % and not more than 32 mass % and hydrofluoric acid having a hydrogen fluoride concentration of not less than 6 mass % and not more than 22 mass %.

10. The method of manufacturing the crystalline silicon wafer (1) according to claim 9, wherein abrasive grains each having a grain size of not less than 10 µm and not more than 40 µm are used in said step of slicing by using the wire saw.

11. A method of manufacturing a crystalline silicon solar cell (11), comprising the steps of: slicing a crystalline silicon ingot by using a wire saw; and etching said sliced crystalline silicon ingot by using an etching liquid containing nitric acid having a nitric acid concentration of not less than 15 mass % and not more than 32 mass % and hydrofluoric acid having a hydrogen fluoride concentration of not less than 6 mass % and not more than 22 mass %.

12. The method of manufacturing the crystalline silicon solar cell (11) according to claim 11, wherein the method comprises the steps of forming a pn junction at said etched crystalline silicon wafer (1), and forming an electrode at said etched crystalline silicon wafer (1).
